# EUROPEAN PATENT SPECIFICATION

(11) **EP 4 012 626 B1**
(45) Date of publication and mention of the grant of the patent: **10.09.2025**
(21) Application number: 20212481.4
(22) Date of filing: 08.12.2020
(51) Int. Cl.: G06N 10/40

(54) **QUBIT READOUT**
QUBIT-AUSLESUNG
LECTURE DE BITS QUANTIQUES

(43) Date of publication of application: 15.06.2022
(73) Proprietor: IQM Finland Oy, 02150 Espoo (FI)
(72) Inventor: Hassel, Juha, 02150 Espoo (FI); Sevriuk, Vasilii, 02150 Espoo (FI); Heinsoo, Johannes, 02150 Espoo (FI); Tan, Kuan, 02150 Espoo (FI); Möttönen, Mikko, 02150 Espoo (FI)
(74) Representative: Papula Oy

(56) References cited:
- HAO HSU ET AL: "Tunable refrigerator for non-linear quantum electric circuits", ARXIV.ORG, CORNELL UNIVERSITY LIBRARY, 201 OLIN LIBRARY CORNELL UNIVERSITY ITHACA, NY 14853, 16 June 2020 (2020-06-16), XP081686310, DOI: 10.1103/PHYSREVB.101.235422
- ERIC HYYPPA ET AL: "Calibration of cryogenic amplification chains using normal-metal--insulator--superconductor junctions", ARXIV.ORG, CORNELL UNIVERSITY LIBRARY, 201 OLIN LIBRARY CORNELL UNIVERSITY ITHACA, NY 14853, 1 April 2019 (2019-04-01), XP081163332
- KUAN YEN TAN ET AL: "Quantum Circuit Refrigerator", ARXIV.ORG, CORNELL UNIVERSITY LIBRARY, 201 OLIN LIBRARY CORNELL UNIVERSITY ITHACA, NY 14853, 15 June 2016 (2016-06-15), XP081362891, DOI: 10.1038/NCOMMS15189
- MATTI SILVERI ET AL: "Theory of quantum-circuit refrigeration by photon-assisted electron tunneling", ARXIV.ORG, CORNELL UNIVERSITY LIBRARY, 201 OLIN LIBRARY CORNELL UNIVERSITY ITHACA, NY 14853, 22 June 2017 (2017-06-22), XP080771774, DOI: 10.1103/PHYSREVB.96.094524

## Description

### TECHNICAL FIELD

The present disclosure relates to quantum computing, and more particularly to an arrangement for qubit readout and to a quantum computing system.

### BACKGROUND

In quantum computing, the basic operational unit is typically a two-level quantum system generally referred to as a qubit. After a quantum computation has been performed, for example, using a plurality of qubits, the state of one or more qubits needs the be read in order to obtain an intermediate or a final result of the computation. In addition to readout, the qubit state initialization is often needed, preferably in an efficient manner, for subsequent quantum computations. Hao Hsu et al: "Tunable refrigerator for non-linear quantum electric circuits", published on 16 June 2020, discloses a quantum-circuit refrigerator, which consists of a SINIS junction, in the case of non-linear quantum electric circuits such as superconducting qubits.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter.

The invention is set out in independent claims 1, 14 and 15. Preferred aspects of the invention are set out in the dependent claims.

Many of the attendant features will be more readily appreciated as they become better understood by reference to the following detailed description considered in connection with the accompanying drawings.

### DESCRIPTION OF THE DRAWINGS

In the following, example embodiments are described in more detail with reference to the attached figures and drawings, in which:
Fig. 1 illustrates a schematic representation of an arrangement for qubit readout according to an embodiment;
Fig. 2 illustrates a schematic representation of an arrangement for qubit readout comprising a SINIS junction according to an embodiment;
Fig. 3 illustrates a schematic representation of an arrangement for qubit readout comprising a NIS junction according to an embodiment;
Fig. 4 illustrates a schematic representation of an arrangement for qubit readout comprising a SIS junction according to an embodiment;
Fig. 5 illustrates a schematic representation of an arrangement for qubit readout comprising a direct coupling between a charge storage and a SET according to an embodiment;
Fig. 6 illustrates a schematic representation of an arrangement comprising a direct coupling between a charge storage and a SET for qubit readout according to another embodiment;
Fig. 7 illustrates a schematic representation of controllable energy relaxation structure comprising a SINIS junction according to an embodiment;
Fig. 8 illustrates a plot representation of computed tunnelling rates in a QCR coupled to a resonator according to an embodiment;
Fig. 9 illustrates a schematic representation of a quantum computing system according to an embodiment;
Fig. 10 illustrates a schematic representation of a control unit according to an embodiment; and
Fig. 11 illustrates a flow chart representation of a method for qubit readout according to an embodiment.

In the following, like reference numerals are used to designate like parts in the accompanying drawings.

### DETAILED DESCRIPTION

In the following description, reference is made to the accompanying drawings, which form part of the disclosure, and in which are shown, by way of illustration, specific aspects in which the present disclosure may be placed. It is understood that other aspects may be utilised, and structural or logical changes may be made without departing from the scope of the present disclosure. The following detailed description, therefore, is not to be taken in a limiting sense, as the scope of the present disclosure is defined be the appended claims.

For instance, it is understood that a disclosure in connection with a described method may also hold true for a corresponding device or system configured to perform the method and vice versa. For example, if a specific method step is described, a corresponding device may include a unit to perform the described method step, even if such unit is not explicitly described or illustrated in the figures. On the other hand, for example, if a specific apparatus is described based on functional units, a corresponding method may include a step performing the described functionality, even if such step is not explicitly described or illustrated in the figures. Further, it is understood that the features of the various example aspects described herein may be combined with each other, unless specifically noted otherwise.

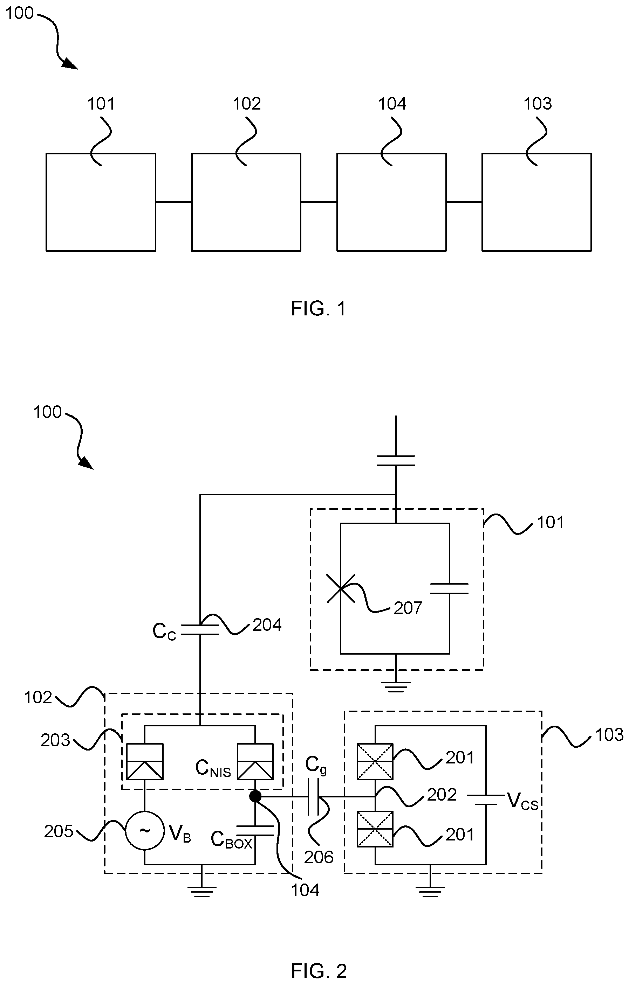

Fig. 1 illustrates a schematic representation of an arrangement 100 for qubit readout according to an embodiment.

According to an embodiment, the arrangement 100 comprises at least one qubit 101.

The at least one qubit 101 may have a ground state **|*g*〉.** Herein, the ground state may refer to a quantum state of the qubit with the lowest energy.

The at least one qubit 101 may further have at least one excited state. The at least one excited state may comprise a lowest excited state **|*e*〉.** Herein, the lowest excited state may refer to a quantum state of the qubit with the second lowest energy.

The ground state and the lowest excited state of a qubit may correspond to the computational basis of the qubit. For example, the ground state **|*g*〉** may correspond to the **|0〉** state of the qubit and the lowest excited state **|*e*〉** may correspond to the **|1〉** state of the qubit or vice versa. Other quantum states of a qubit may be referred to as non-computational states.

The energy gap between the ground state and the lowest excited state may correspond to a resonance frequency of the qubit. The energy gap may also be referred to as the qubit energy, and the corresponding frequency as the qubit frequency.

The at least one excited state may further comprise a second lowest excited state **|*f*〉.** The second lowest excited state has a higher energy than the ground state **|g)** and the lowest excited state **|*e*〉.**

The arrangement 100 further comprises a structure acting as a controllable energy relaxation channel, from here on referred to as a controllable energy relaxation structure 102, comprising at least one junction and coupled to the at least one qubit 101.

The controllable energy relaxation structure 102 is configured to absorb, in response to a control signal, at least one photon from the at least one qubit 101 via photon-assisted tunnelling of a charge through the at least one junction. In this process the energy of the photon corresponds to the qubit energy.

The controllable energy relaxation structure 102 may also be referred to as an environment, an engineered environment, a bath, a dissipation source, or similar.

The control signal may also be referred to as control voltage, a bias voltage, junction bias voltage, or similar. The control signal may correspond to a voltage over the at least one junction. The voltage over the at least one junction may be time-independent or time-dependent.

The controllable energy relaxation structure 102 may absorb the at least one photon from the at least one qubit 101 conditional to the at least one qubit 101 being in an excited state. If the at least one qubit 101 is in the ground state, the controllable energy relaxation structure 102 cannot absorb photon energy from the at least one qubit 101. Thus, the photon-assisted tunnelling cannot occur, and tunnelling through the junction is not favourable since a charge does not have sufficient energy to tunnel through the at least one junction. In some embodiments, the controllable energy relaxation structure 102 is designed and tuned in such manner that the photon-assisted tunnelling, as control signal is applied, is very likely conditional to the qubit being in an excited state, whereas all other possible tunnelling mechanisms are very unlikely. Therefore, an event of tunnelling is to a high probability an indication of the qubit being in an excited state.

The arrangement 100 further comprises a charge storage 104. The charge storage 104 is configured to store the tunnelled charge.

The charge storage 104 may also be referred to as a single-charge storage, a charge box, a single-charge box, or similar.

The tunnelled charge may correspond to, for example, an electron, a Cooper pair, an electron hole, or a quasi-particle, depending on the type of the at least one junction.

The charge storage 104 may be embodied in the controllable energy relaxation structure 102. Alternatively, the charge storage 104 may be a separate element from the controllable energy relaxation structure 102.

The arrangement 100 further comprises a charge sensing structure 103 coupled to the charge storage 104. The charge sensing structure 103 is configured to provide a readout signal in response to detecting the tunnelled charge in the charge storage 104.

The readout signal may also be referred to as a readout voltage, a readout current, a qubit readout signal, or similar.

Since the photon-assisted tunnelling is conditional to the at least one qubit 101 being in an excited state, the readout signal can indicate the state of the at least one qubit 101. Further the photon-assisted tunnelling can reset the at least one qubit 101 into the ground state. Thus, the arrangement 100 may provide a qubit readout and/or a qubit reset capability. Further, the arrangement 100 may be integrated in a compact manner within a quantum circuit.

Herein, when two elements are electromagnetically coupled, the elements may have an electromagnetic connection between each other. The electromagnetic connection may comprise any number of electrical components/elements, such as capacitors, inductors, mutual inductances, transmission lines etc.

Although some embodiments and analysis disclosed herein may refer to specific implementations of the controllable energy relaxation structure 102, it should be appreciated that the controllable energy relaxation structure 102 may be implemented using, for example, any controllable energy relaxation structure with a coupling to the at least one qubit 101.

The controllable energy relaxation structure 102 may be electromagnetically coupled to the at least one qubit 101. The controllable energy relaxation structure 102 may be controllable in the sense that its tendency to photon-assisted tunnelling, conditional to the at least one qubit 101 being in an excited state, depends on the control signal.

It should be appreciated that although the at least one qubit 101 and the controllable energy relaxation structure 102 may be electromagnetically coupled continuously, the relaxation rate of the qubit 101 as inflicted by the controllable energy relaxation structure 102 may still be selective, if the properties of the relaxation structure 102 can be controlled. The effect of the control signal can, for example, be such that when the control signal is applied the photon-assisted tunnelling becomes energetically favourable with photon energies corresponding to the difference of the energies of the excited and ground states of the qubit 101. In some embodiments, when the control signal is not applied, the photon assisted tunnelling is highly unlikely irrespective of the qubit 101 state.

Herein, when the properties of the controllable energy relaxation structure 102 are controllable, the strength of interaction between the controllable energy relaxation structure 102 and other objects may be controlled and/or turned on or off. It should be appreciated that even if there is a continuous connection, such as an electrical/capacitive/inductive connection, between two elements, the interaction between the elements can be tuned.

According to an embodiment, the at least one qubit 101 comprises at least one superconductive qubit.

According to an embodiment, the at least one qubit 101 comprises at least one Josephson junction.

According to an embodiment, the at least one qubit 101 comprises a transmon qubit. Alternatively, the at least one qubit 101 may comprise any other type of qubit, such as, a flux qubit, a charge qubit, a phase qubit, or a fluxonium qubit.

Although some embodiments may be disclosed herein with reference to a certain type of qubit, these qubit types are only exemplarily. In any embodiment disclosed herein, the at least one qubit 101 may be implemented in various ways and using various technologies.

The arrangement 100 may be embodied in, for example, a quantum computing device. Such a quantum computing device may comprise a plurality of qubits for performing quantum computation. Each such qubit may be implemented using the arrangement 100.

The arrangement 100 may be realized, for example, in a superconducting circuit architecture.

When the arrangement 100 is operational, the at least one qubit 101, the controllable energy relaxation structure 102, the charge storage 104, and/or the charge sensing structure 103 may be physically located in a cryostat or similar. The cryostat may cool the at least one qubit 101 and other components of the arrangement 100, such as the controllable energy relaxation structure 102, to cryogenic temperatures. This may be required if the at least one qubit 101 correspond to, for example, a superconductive qubit.

Fig. 2 illustrates a schematic representation an arrangement 100 comprising a SINIS junction according to an embodiment.

It should be appreciated that only some elements and/or couplings between elements are illustrated in the embodiments disclosed herein. When the arrangement 100 is used in, for example, quantum computing applications, the at least one qubit 101 may be coupled to other qubits and elements used to control the at least one qubit 101.

According to an embodiment, the at least one junction of the controllable energy relaxation structure 102 comprises a superconductor - insulator - normal metal - insulator - superconductor (SINIS) junction. The at least one qubit 101 may be electromagnetically coupled to the normal metal of the SINIS junction of the controllable energy relaxation structure 102. The control signal may correspond to a bias voltage 205 over the SINIS junction.

In the embodiment of Fig. 2, the at least one qubit 101 is a transmon qubit comprising a Josephson junction 207 and the at least one junction in the controllable energy relaxation structure 102 comprises a SINIS junction 203. A SINIS junction may be considered to comprise two NIS junctions. A controllable energy relaxation structure 102 comprising a SINIS junction 203 may also be referred to as a quantum circuit refrigerator (QCR). The at least one qubit 101 is coupled to the QCR via a coupling capacitance ***C_{C}*** 204.

In the embodiment of Fig. 2, the control signal may correspond to the bias voltage *V_{B}* over the SINIS junction. The bias voltage *V_{B}* provides a signal controlling the likelihood of photon-assisted tunnelling (conditional to the qubit 101 being in an excited state). In this sense, the arrangement 100 is capable of performing a reset of the qubit 101. However, the arrangement 100 is also capable of storing of the electron in the charge storage 104 after the photon-assisted tunnelling event. The stored electron can then be sensed by the charge sensing structure 103.

According to an embodiment, the charge storage 104 is formed by at least a capacitive coupling between the at least one qubit 101 and the controllable energy relaxation structure 102 and a capacitance of the at least one junction of the controllable energy relaxation structure 102.

According to an embodiment, the charge storage 104 is formed by at least a capacitive coupling between the at least one qubit 101 and the controllable energy relaxation structure 102, a capacitance of the at least one junction of the controllable energy relaxation structure 102, and a capacitive coupling between the charge sensing structure 103 and the controllable energy relaxation structure 102.

For example, in the embodiment of Fig. 2, the charge storage 104 comprises a single-charge box formed by the capacitance of the QCR, a capacitance ***C_{NIS},** a* capacitance ***C_{BOX},*** and the gate-capacitor ***C_{g}*** 206 of the charge sensing structure 103.

According to an embodiment, the charge sensing structure 103 comprises a structure where electron transport at the output is affected by Coulomb blockade. In an embodiment, the charge sensing structure 103 is coupled to the charge storage 104 in such a way that the stored charge modifies the Coulomb blockade of the charge sensing structure 103.

According to an embodiment, the charge sensing structure 103 comprises a Coulomb blockade controlling the readout signal. The Coulomb blockade of the charge sensing structure may be modified by the charge stored in the charge storage 104 coupled to the charge sensing structure 103.

According to an embodiment, the charge sensing structure 103 comprises a single electron transistor, SET, a single Cooper pair transistor, SCPT, a radio-frequency single electron transistor, RF-SET, an inductive single electron transistor, L-SET, or a charge sensing structure based on semiconductor quantum dots, carbon nanotubes, quantum point contacts, or two-dimensional materials.

According to an embodiment, the charge sensing structure 103 comprises a single-electron transistor (SET) or a single Cooper pair transistor (SCPT) comprising a conductive island 202. The conductive island 202 of the SET or SCPT may be coupled to the charge storage 104. The readout signal may correspond to an electrical current through the SET or SCPT. The conductive island 202 may be, for example, capacitively coupled to the charge storage 104. The SET may be voltage biased.

A SET or SCPT may comprise two normal conducting or superconducting tunnel junctions 201 and a conductive island 202 between the tunnel junctions 201. The electrical potential of the island 202 can be tuned with at least one gate electrode to optimize the operating point for the charge sensing structure 103. Applying a voltage at the gate electrode (not shown in the Figures for clarity), the island 202 can be tuned close to a threshold where the presence of a charge in the charge storage 104 has a large impact in the charge transport at the output of the charge sensing structure. For example, when the tunnelled charge is in the charge storage 104 and the SET is biased by a voltage ***V_{CS},*** a current can flow through tunnel junctions 201 and the SET. This current can function as the readout signal.

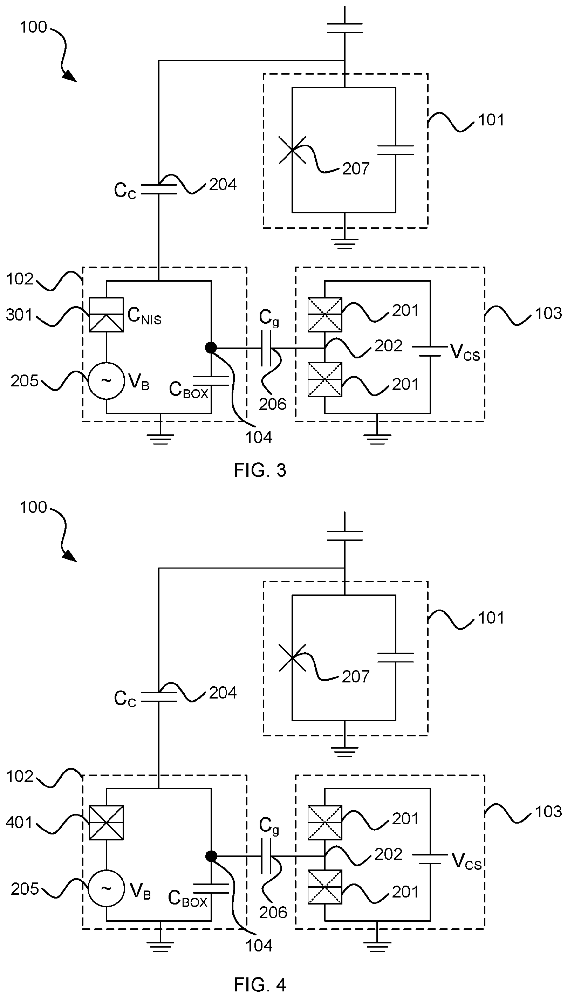

Fig. 3 illustrates a schematic representation an arrangement 100 comprising a NIS junction according to an embodiment.

According to an embodiment, the at least one junction of the controllable energy relaxation structure 102 comprises at least one normal metal - insulator - superconductor (NIS) junction or at least one superconductor - insulator - superconductor (SIS) junction.

In the embodiment of Fig. 3, at least one junction of the controllable energy relaxation structure 102 comprises a NIS junction 301.

Photon-assisted tunnelling involves a tunnelling process where the qubit excitation energy enables a tunnelling process which otherwise is not favourable due to an energy barrier of the at least one junction. In case of solutions based on NIS junctions, such as in the embodiments of Fig. 2 and Fig. 3, the barrier is the superconducting energy gap, possibly accompanied by Coulomb gap depending on the charging energies.

Fig. 4 illustrates a schematic representation an arrangement 100 comprising a SIS junction according to an embodiment. In the embodiment of Fig. 4, the at least one junction of the controllable energy relaxation structure 102 comprises a SIS junction 401.

In superconducting implementations of the controllable energy relaxation structure 102, such as the embodiment of Fig. 4, the tunnelling can be based on single Cooper pair tunnelling, and the energy gap is the Coulomb gap related to the charging energy. Alternatively, also in all-superconducting versions, the tunnelling can be based on quasiparticle tunnelling, in which case energy gap can be again a combination of the superconducting gap and the Coulomb gap. All-superconducting version could be beneficial as the fabrication technique can be readily compatible with the qubit process with no extra layers.

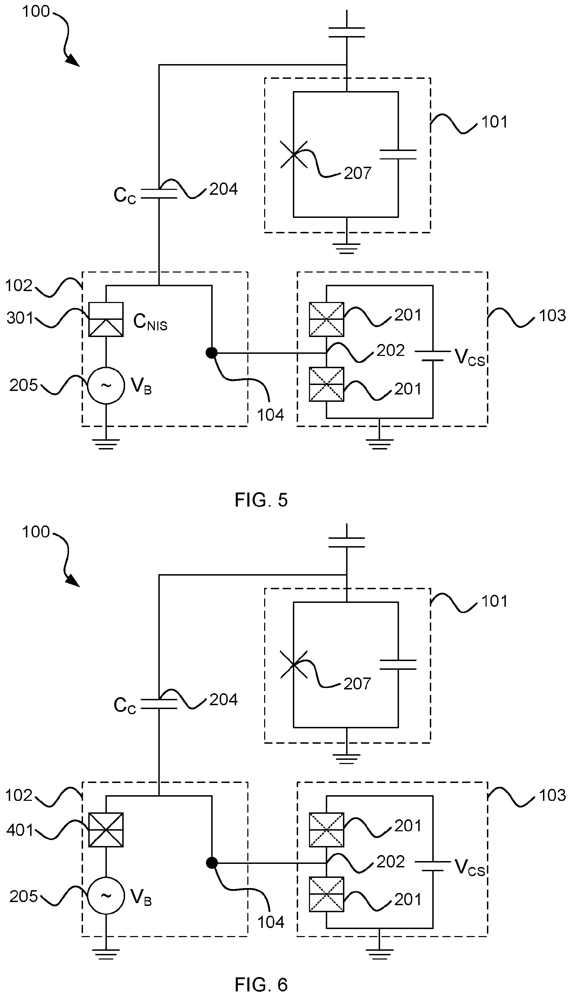

Fig. 5 illustrates a schematic representation an arrangement 100 comprising a direct coupling between a charge storage 104 and a SET according to an embodiment. In the embodiment of Fig. 5, the at least one junction of the controllable energy relaxation structure 102 comprises a NIS junction 301 and the charge storage 104 is directly electrically coupled to the conductive island 202 of the SET.

Fig. 6 illustrates a schematic representation an arrangement 100 comprising a direct coupling between a charge storage 104 and a SET according to an embodiment. In the embodiment of Fig. 6, the at least one junction of the controllable energy relaxation structure 102 comprises a SIS junction 401 and the charge storage 104 is directly electrically coupled to the conductive island 202 of the SET.

In the embodiments of Figs. 2 - 4, the charge-sensing device 103 is capacitively coupled to the charge storage 104. In directly coupled embodiments, such as the embodiment of Fig. 5 or the embodiment of Fig. 6, the charge (Cooper pair or quasiparticle) can tunnel directly to the conductive island 202 of the SET by the photon-assisted tunnelling process in the at least one junction. In these embodiments, the charge signal as seen by the charge sensing structure 103 may be increased. Yet, these embodiments may have restrictions as the charge decay through the charge sensing structure 103 may set constraints to the design.

Although the SET has been used as an example of the charge sensing structure 103 in the embodiments of Figs. 2 - 6, the charge sensing structure 103 may be implemented in various other ways. The common feature is that they have sufficient resolution to sense the tunnelled charge in the charge storage 104.

In certain embodiments, the charge sensing structure 103 is any structure in which the charge in the charge storage 104 affects the strength of the Coulomb blockade in the charge sensing structure 103, and in which the electrical transport at the output of the charge sensing structure 103 is dependent on the strength of the Coulomb blockade. The electrical transport may refer to current or voltage at the output of the charge sensing structure 103. In some embodiments the changes in the electrical transport properties are sensed by probing with a radio-frequency signal.

In any embodiment disclosed herein, the charge sensing structure 103 may comprise, for example, a single-electron transistor (SET) producing a charge-dependent current. The SET may be, for example, a superconducting SET, also referred to a single Cooper pair transistor (SCPT), a normal SET, or an inductive SET (L-SET). The SET may be read out with radio-frequency signals. Options also include devices based on quantum point contacts (QPCs), carbon nanotubes (CNTs), 2D materials such as graphene, or semiconductor-based single electron devices such as semiconductor quantum dots. In some embodiments, there is a further tuning option through gate-based tuning of the tunnel coupling.

It may be advantageous to integrate the charge sensing structure 103 to a separate chip using, for example, flip-chip bonding. The flip-chip bonding can further enable hybridizing different technologies such as those related to the fabrication of the charge sensing structure 103. As an example, one can anticipate an option to hybridize a semiconductor quantum-dot-based charge sensing structure 103 with a superconducting qubit.

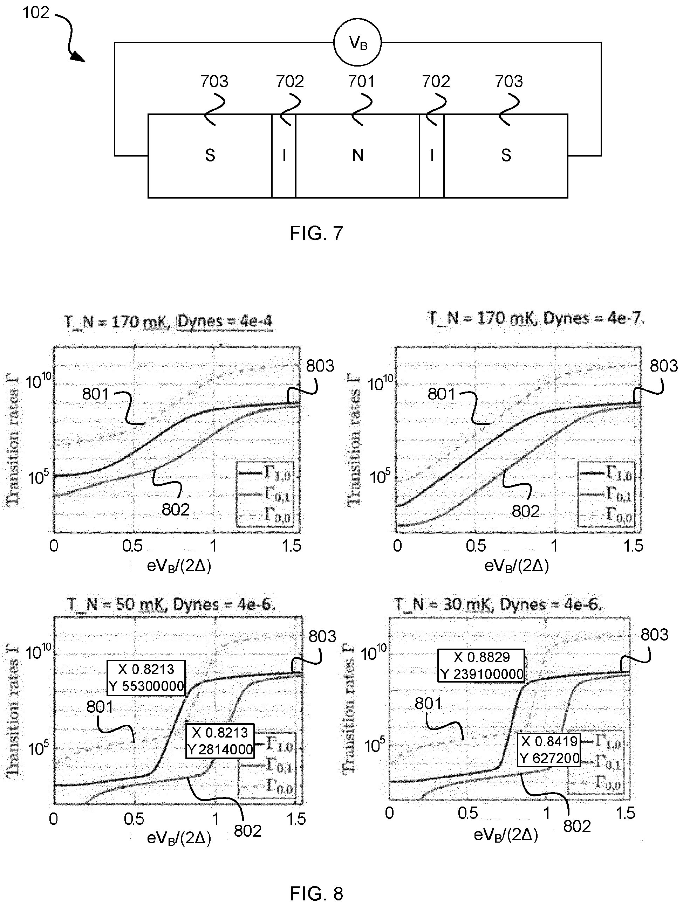

Fig. 7 illustrates a schematic representation of a controllable energy relaxation structure 102 comprising a SINIS junction according to an embodiment. The at least one junction of the controllable energy relaxation structure 102 may be implemented, for example, as in the embodiment of Fig. 7.

In the embodiment of Fig. 7, the controllable energy relaxation structure 102 comprises two NIS junctions. These two NIS junctions form a superconductor 703 - insulator 702 - normal metal 701 - insulator 702 - superconductor 703 (SINIS) junction. The SINIS junction may be biased by a bias voltage ***V_{B}.***

The energy relaxation properties of the SINIS junction can be controlled by the bias voltage ***V_{B}.*** The SINIS junction may be referred to as a quantum circuit refrigerator (QCR). In some embodiments, the bias voltage ***V_{B}*** is time-dependent.

The at least one qubit 101 may be electromagnetically coupled to the SINIS junction of the controllable energy relaxation structure 102. Thus, the energy relaxation structure 102 may absorb photon energy from the at least one qubit 101.

The controllable energy relaxation structure 102 may absorb photons from the at least one qubit 101 at bias voltages where an electron needs to receive an additional energy quantum from the at least one qubit 101 to overcome the Bardeen-Cooper-Schrieffer (BCS) energy gap in the superconductor 703. For example, if ***eV_{B}<2Δ*,** there is ideally only a small probability of electron tunnelling through the SINIS junction spontaneously. Moreover, if ***eV_{B}* + *hf>2Δ,*** an electron can tunnel via photon-assisted tunnelling with the absorption of a photon of energy ***hf.*** Here **Δ** is the BCS gap or superconducting gap of the superconducting electrode material, ***V_{B}*** is the bias voltage, **e the** electron charge, ***h*** the Planck constant, and ***f*** the frequency of the photon. If, furthermore, the energy ***hf*** corresponds to the energy difference of the excited and ground states of the qubit, the qubit is in its excited state, and if the SINIS junction is electromagnetically coupled to the qubit, the qubit can relax from the excited state to the ground state through the relaxation channel provided by the photon-assisted tunnelling in the SINIS junction. However, if ***eV_{B}* + *hf<2Δ,*** the photon-assisted tunnelling is ideally forbidden. Thus, a time-dependent control signal ***V_{B}*** can be used to trigger a readout process of the qubit.

Fig. 8 illustrates a plot representation of computed tunnelling rates in a QCR coupled to a resonator according to an embodiment. In addition to above discussed ideal situation the rates are computed from a model including a finite temperature ***T_{N}*** and a junction quality quantified by the so-called Dynes parameter.

The model used for the embodiment of Fig. 8 does not include the charging effects related to the charge storage 104 and the charge sensing structure 103 coupled to the charge storage. This is anticipated to be addressable by modifying the bias conditions. Indeed, the presence of the charge storage 104 and the charge sensing structure 103, as well as the Coulomb blockade related to it, may impact the considered voltage scales in an order of e/C_{Σ} (with e the electron charge and C_{Σ} the total capacitance related to the charge storage 104, including contributions from the capacitances of the controllable energy relaxation structure 102 and charge sensing device 103). If **Δ** is much greater than e/C_{Σ} the correction can be neglected. The model also assumes a linear resonator rather than a qubit, but the cases may be considered as essentially equivalent if we are only considering the lowest two states of the qubit. Thus, the model can be considered sufficient for illustrating the operating principle of at least some embodiments of the arrangement 100.

In the embodiment of Fig. 8, **Γ*_{i,j}*** denotes the transition rate of the resonator (qubit) from state **|*i*〉** to state **|*j*〉.** Thus, **Γ_{1,0},** represented by curve 803, corresponds to the photon-assisted tunnelling process, where a photon is emitted from the qubit and the qubit transitions from the lowest excited state to the ground state. **Γ_{0,1},** represented by curve 802, corresponds to a process in which the qubit absorbs a photon and transitions from the ground state to the lowest excited state. **Γ_{0,0},** represented by curve 801, corresponds to a process in which the qubit remains in the ground state but tunnelling still occurs in the at least one junction. This may be referred to as elastic tunnelling.

The desired photon-assisted tunnelling event is depicted in the embodiment Fig. 8 by curve 803 which shows the photon-assisted tunnelling rate conditional to the at least one qubit 101 being in an excited state. The interpretation is that as controllable energy relaxation structure 102 is in the off-state **(*V_{B}* /2Δ ≈ 0,** with ***V_{B}*** being the bias voltage of the QCR and **Δ** being the superconducting gap of the material), i.e. no control signal is applied, the tunnelling probability is low. As ***V_{B}*/*2*Δ** is increased close to unity, the rate increases by several orders of magnitude. Thus, the most basic case is to realize the control signal as a unipolar voltage pulse with an amplitude ***V_{B}*/*2*Δ** close to but less than unity, and duration **Δ*t*** such that the odds are that the qubit decays to the ground state with a high probability during the process.

One challenge is to prevent the effect of any unwanted tunnelling events. From the embodiment of Fig. 8, it appears that the so-called elastic tunnelling independent of the qubit state, represented by curve 801, often exceeds the photon-assisted tunnelling, thus potentially causing a "false positive" of qubit being in an excited state to the readout signal. Therefore, the parameter regime of interest may be where, during the reset/readout pulse, the photon-assisted tunnelling **Γ_{1,0}** substantially exceeds the elastic tunnelling **Γ_{0,0}.**

Beneficial operating points can be found if the operating temperature ***T_{N}*** is low enough, and if the Dynes parameter describing the deviation of superconductor density of states from ideal (or spurious environment-induced photon-assisted tunnelling) is low enough. Potential high-fidelity operating points in this respect are labelled in the bottom plots of Fig. 8. Examples of such points are when ***T_{N}* = 50** millikelvin (mK), the Dynes parameter is **4 × 10⁻⁶,** and ***eV_{B}*/*2*Δ ≈ 0.8213** or when ***T_{N}* = 30** mK, Dynes parameter is **4 × 10⁻⁶,** and ***eV_{B}*/*2*Δ ≈ 0.8829.** It can be also noted the criterion **Γ_{1,0} »Γ_{0,0}** at the operating point essentially follows from the readout requirement whereas this criterion may not be necessary for a pure reset process of the at least one qubit 101. One can further note that the advantageous operating temperatures are available in common qubit environments, and Dynes parameters down to **0.5 × 10⁻⁶** are reported in the literature.

According to an embodiment, at least one operating parameter of the at least one junction is configured in such a way that, when the control signal is applied, a photon-assisted tunnelling rate is greater than an elastic tunnelling rate in the at least one junction.

According to an embodiment, the at least one operating parameter comprises at least an operating temperature below 80 millikelvin and a Dynes parameter below 10⁻⁴.

The readout error can be minimized by optimizing the readout pulse duration. In a simplified model, we consider the readout error events of a) failed photon assisted tunneling when the qubit is in the excited state, and b) tunneling event even when the qubit is in the ground state. Assuming for simplicity a rectangular reset/readout pulse of duration Δt, the fidelity (i.e. the probability of correct measurement result) corresponding to a) is, from the properties of exponentially distributed random events, ***P*₁ = 1 -exp(-Γ_{1*,*0} Δ*t*),** i.e. the probability of photon assisted tunneling conditional to the qubit being in the excited state. The fidelity corresponding to b) is ***P*₂ = exp(*-*Γ_{0,0} *Δ*t),** i.e. the probability of photon not tunneling by the inelastic process independently of the qubit state. The maximum overall fidelity can be defined as the worst case, i.e., **min(*P*₁, *P*₂).** As ***P*₁** increases and ***P*₂** decreases with increasing Δt the optimum is at ***P*₁ = P₂.** For the case of the Dynes parameter of 0.5 x 10-6 and temperature ***T_{N}*** of 10 mK and using a model similar to that applied in Fig. 8 for rates **Γ**_{0,0} and **Γ**_{1,0} the maximum fidelity of about 99.8% corresponding to the readout pulse length of about 21 ns.

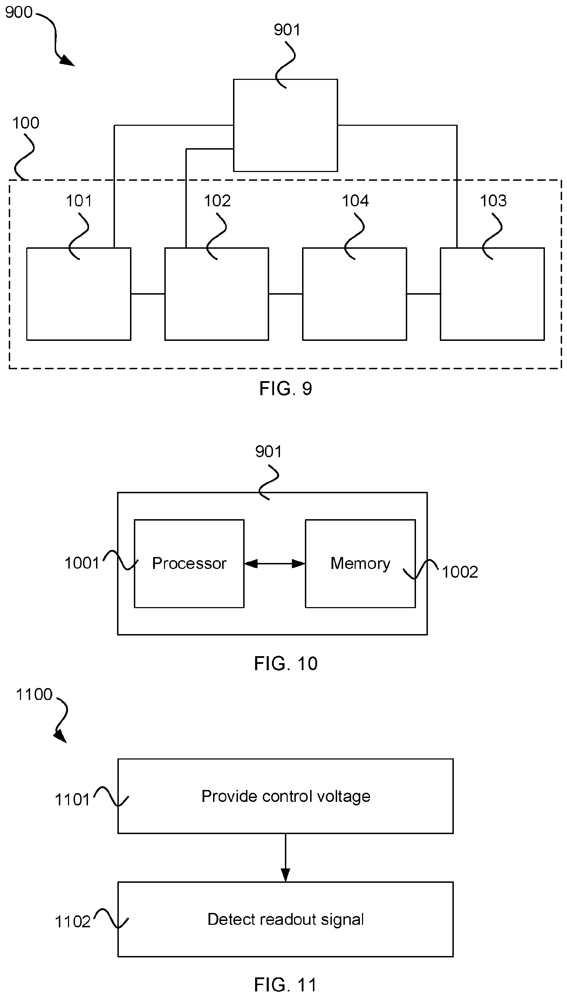

Fig. 9 illustrates a schematic representation of a quantum computing system 900 according to an embodiment.

According to an embodiment, the quantum computing system 900 comprises the arrangement 100 and a control unit 901 coupled to the arrangement 100. The control unit 901 may be configured to provide the control signal to the controllable energy relaxation structure 102 of the arrangement 100. The control unit 901 may be further configured to detect the readout signal provided by the charge sensing structure 103 of the arrangement 100.

In some embodiments, the quantum computing system 900 may comprise a plurality of qubits. The readout of each qubit in the plurality of qubits may be implemented using the arrangement 100. The control unit 901 may be coupled to each such arrangement 100 and the control unit 901 may control each arrangement 100 in a manner disclosed herein. Further, the control unit 901 may perform quantum computation using the plurality of qubits.

The control unit 901 may be configured to directly measure the readout signal provided by the charge sensing structure 103. Alternatively, there may be other stages, such as one or more amplifiers, between the control unit 901 and the charge sensing structure 103. The need for such other stages may depend on the strength of the signal provided by the charge sensing structure 103 and/or the sensitivity of the control unit 901. Further, there may be other elements between the charge sensing structure 103 and the control unit 901, such as an analogue-to-digital converter, that may adapt the readout signal to a format suitable for the control unit 901.

After the control unit 901 has detected the readout signal, the tunnelled charge should be removed from the charge storage 104 to, in turn, initialize the charge readout structure 103. One solution is to apply pulse shaping to the control signal in such a way that the control signal has a shape, e.g. a bipolar pulse shape (likely asymmetric bipolar pulse shape), such that after the actual trigger enabling the photon-assisted tunnelling, there is a pulse emptying the charge storage 104 through elastic tunnelling. Also, more complex pulse shapes can be applied.

According to an embodiment, the control signal comprises at least one unipolar or bipolar voltage pulse.

The bipolar voltage pulse may comprise a first polarity part and a second polarity part. The first polarity part and the second polarity part may have opposing polarities. For example, the first polarity part may correspond to a positive voltage and the second polarity part may correspond to a negative voltage or vice versa. The first polarity parts and the second polarity part may be temporally consecutive.

An amplitude of the at least one unipolar voltage pulse or an amplitude of a first polarity part of the bipolar voltage pulse may be configured to enable the photon-assisted tunnelling in the at least one junction.

According to an embodiment, an amplitude of the at least one unipolar voltage pulse or of a first polarity part of the bipolar voltage pulse corresponds an energy less than a superconducting gap energy of the at least one junction of the controllable energy relaxation structure 102 and greater than a difference of the superconducting gap energy of the at least one junction of the controllable energy relaxation structure 102 and a qubit energy of the at least one qubit 101.

An amplitude of a second polarity part of the bipolar voltage pulse may be configured to enable elastic tunnelling of the tunnelled charge in the at least one junction.

The control unit 901 may be configured to detect the readout signal after providing the first polarity part of the bipolar voltage pulse and before applying the second polarity part of the bipolar voltage pulse.

According to an embodiment, the at least one bipolar voltage pulse is temporally asymmetric.

Alternatively or additionally, the tunnelled charge may be removed from the charge storage by using a charge leakage channel.

According to an embodiment, the arrangement 100 further comprises a charge leakage channel coupled to the charge storage 104. The charge leakage channel may be configured to cause the tunnelled charge to decay in the charge storage 104.

The leakage channel may, for example, replace ***C_{BOX}.*** The leakage channel may comprise, for example, a tunnel junction or a resistor through which the tunnelled charge can decay spontaneously. The decay rate may be low enough for the charge sensing structure 103 to be able to detect the tunnelled charge.

Fig. 10 illustrates a schematic representation of a control unit 901 according to an embodiment.

The control unit 901 may comprise at least one processor 1001. The at least one processor 1001 may comprise, for example, one or more of various processing devices, such as a co-processor, a microprocessor, a control unit 901, a digital signal processor (DSP), a processing circuitry with or without an accompanying DSP, or various other processing devices including integrated circuits such as, for example, an application specific integrated circuit (ASIC), a field programmable gate array (FPGA), a microprocessor unit (MCU), a hardware accelerator, a special-purpose computer chip, or the like.

The control unit 901 may further comprise a memory 1002. The memory 1002 may be configured to store, for example, computer programs and the like. The memory 1002 may comprise one or more volatile memory devices, one or more non-volatile memory devices, and/or a combination of one or more volatile memory devices and non-volatile memory devices. For example, the memory 1002 may be embodied as magnetic storage devices (such as hard disk drives, floppy disks, magnetic tapes, etc.), optical magnetic storage devices, and semiconductor memories (such as mask ROM, PROM (programmable ROM), EPROM (erasable PROM), flash ROM, RAM (random access memory), etc.).

The control unit 901 may further comprise other components not illustrated in the embodiment of Fig. 11. The control unit 901 may comprise, for example, an input/output bus for connecting the control unit 901 to the arrangement 100. Further, a user may control the control unit 901 via the input/output bus. The user may, for example, control quantum computation operations performed by the arrangement 100 via the control unit 901 and the input/output bus.

When the control unit 901 is configured to implement some functionality, some component and/or components of the control unit 901, such as the at least one processor 1001 and/or the memory 1002, may be configured to implement this functionality. Furthermore, when the at least one processor 1001 is configured to implement some functionality, this functionality may be implemented using program code comprised, for example, in the memory.

The control unit 901 may be implemented using, for example, a computer, some other computing device, or similar.

Fig. 11 illustrates a flow chart representation of a method 1100 for qubit readout according to an embodiment.

According to an embodiment, the method 1100 comprises providing 1101 the control signal to the controllable energy relaxation structure of the arrangement.

The method 1100 may further comprise detecting 1102 the readout signal provided by the charge sensing structure of the arrangement.

The method 1100 may be performed by, for example, the control unit 901.

Any range or device value given herein may be extended or altered without losing the effect sought. Also any embodiment may be combined with another embodiment unless explicitly disallowed.

It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item may refer to one or more of those items.

The term 'comprising' is used herein to mean including the method, blocks or elements identified, but that such blocks or elements do not comprise an exclusive list and a method or apparatus may contain additional blocks or elements.

It will be understood that the above description is given by way of example only and that various modifications may be made by those skilled in the art. The above specification, examples and data provide a complete description of the structure and use of exemplary embodiments.

## Claims

1. An arrangement (100) for qubit readout, comprising:
at least one qubit (101);
a controllable energy relaxation structure (102) comprising at least one junction, wherein the controllable energy relaxation structure (102) is coupled to the at least one qubit (101), and is configured to absorb, in response to a control signal, at least one photon from the at least one qubit (101) via photon-assisted tunnelling of a charge through the at least one junction;
a charge storage (104), configured to store the tunnelled charge;
a charge sensing structure (103) coupled to the charge storage (104), configured to provide a readout signal in response to detecting the tunnelled charge in the charge storage (104), wherein the charge sensing structure (103) comprises a Coulomb blockade controlling the readout signal, and wherein the Coulomb blockade of the charge sensing structure is modified by the charge stored in the charge storage (104) coupled to the charge sensing structure (103) and the charge sensing structure (103) comprises a single electron transistor, SET, a single Cooper pair transistor, SCPT, a radio-frequency single electron transistor, RF-SET, an inductive single electron transistor, L-SET, or a charge sensing structure based on semiconductor quantum dots, carbon nanotubes, quantum point contacts, or two-dimensional materials; and
a charge leakage channel coupled to the charge storage (104), configured to cause the tunnelled charge to decay in the charge storage (104).

2. The arrangement (100) according to claim 1, wherein the at least one junction of the controllable energy relaxation structure (102) comprises at least one normal metal - insulator - superconductor, NIS, junction or at least one superconductor - insulator - superconductor, SIS, junction.

3. The arrangement (100) according to claim 1, wherein the at least one junction of the controllable energy relaxation structure (102) comprises a superconductor - insulator - normal metal - insulator - superconductor, SINIS, junction, and wherein the at least one qubit (101) is electromagnetically coupled to the normal metal of the SINIS junction of the controllable energy relaxation structure (102), and wherein the control signal corresponds to a voltage bias over the SINIS junction.

4. The arrangement (100) according to any preceding claim, wherein the charge storage (104) is formed by at least a capacitive coupling between the at least one qubit (101) and the controllable energy relaxation structure (102) and a capacitance of the at least one junction of the controllable energy relaxation structure (102).

5. The arrangement (100) according to any preceding claim, wherein at least one operating parameter of the at least one junction is configured in such a way that, when the control signal is applied, a photon-assisted tunnelling rate is greater than an elastic tunnelling rate in the at least one junction.

6. The arrangement (100) according to claim 5, wherein the at least one operating parameter comprises at least an operating temperature below 80 millikelvin and a Dynes parameter below 10⁻⁴.

7. The arrangement (100) according to any preceding claim, wherein the at least one qubit comprises at least one superconductive qubit.

8. A quantum computing system (900) comprising the arrangement (100) according to any preceding claim and a control unit (901) coupled to the arrangement (100), wherein the control unit (901) is configured to:
provide the control signal to the controllable energy relaxation structure (102) of the arrangement; and
detect the readout signal provided by the charge sensing structure (104) of the arrangement.

9. The quantum computing system (900) according to claim 8, wherein the control signal comprises at least one unipolar voltage pulse.

10. The quantum computing system (900) according to claim 9, wherein an amplitude of the at least one unipolar voltage pulse corresponds an energy less than a superconducting gap energy of the at least one junction of the controllable energy relaxation structure and greater than a difference of the superconducting gap energy of the at least one junction of the controllable energy relaxation structure and a qubit energy of the at least one qubit.

11. The quantum computing system (900) according to claim 8, wherein the control signal comprises at least one bipolar voltage pulse.

12. The quantum computing system (900) according to claim 11, wherein the at least one bipolar voltage pulse is temporally asymmetric.

13. The quantum computing system (900) according to any of claims 11 - 12, wherein an amplitude of a first polarity part of the at least one bipolar voltage pulse corresponds an energy less than a superconducting gap energy of the at least one junction of the controllable energy relaxation structure and greater than a difference of the superconducting gap energy of the at least one junction of the controllable energy relaxation structure and a qubit energy of the at least one qubit.

14. A method (800) for qubit readout in the arrangement according to any of claims 1 - 7, comprising:
providing (1101) the control signal to the controllable energy relaxation structure of the arrangement; and
detecting (1102) the readout signal provided by the charge sensing structure of the arrangement.

15. A computer program product comprising instructions, which when executed by the quantum computing system according to any of claims 8-13, cause said quantum computing system to perform the method according to claim 14.

## Patentansprüche

1. Anordnung (100) zur Qubit-Auslesung, umfassend:
mindestens ein Qubit (101);
eine steuerbare Energierelaxationsstruktur (102), die mindestens einen Übergang umfasst, wobei die steuerbare Energierelaxationsstruktur (102) mit dem mindestens einen Qubit (101) gekoppelt ist, und dazu konfiguriert ist, in Antwort auf ein Steuersignal, mindestens ein Photon von dem mindestens einen Qubit (101) über photonenunterstütztes Tunneln einer Ladung durch den mindestens einen Übergang zu absorbieren;
einen Ladungsspeicher (104), der dazu konfiguriert ist, die getunnelte Ladung zu speichern;
eine Ladungserfassungsstruktur (103), die mit dem Ladungsspeicher (104) gekoppelt ist, die dazu konfiguriert ist, ein Auslesesignal in Antwort auf das Detektieren der getunnelten Ladung in dem Ladungsspeicher (104) bereitzustellen, wobei die Ladungserfassungsstruktur (103) eine Coulomb-Blockade umfasst, die das Auslesesignal steuert, und wobei die Coulomb-Blockade der Ladungserfassungsstruktur durch die Ladung modifiziert wird, die in dem Ladungsspeicher (104), der mit der Ladungserfassungsstruktur (103) gekoppelt ist, gespeichert ist, und wobei die Ladungserfassungsstruktur (103) einen Einzelelektronentransistor, SET, einen Ein-Cooper-Paar-Transistor, SCPT, einen Hochfrequenz-Einzelelektronentransistor, RF-SET, einen induktiven Einzelelektronentransistor, L-SET, oder eine Ladungserfassungsstruktur basierend auf Halbleiter-Quantenpunkten, Kohlenstoff-Nanoröhrchen, Quantenpunktkontakten, oder zweidimensionalen Materialien umfasst; und
einen Ladungsverlustkanal, der mit dem Ladungsspeicher (104) gekoppelt ist, der dazu konfiguriert ist, zu verursachen, dass die getunnelte Ladung in dem Ladungsspeicher (104) zerfällt.

2. Anordnung (100) gemäß Anspruch 1, wobei der mindestens eine Übergang der steuerbaren Energierelaxationsstruktur (102) mindestens einen Normalmetall-Isolator-Supraleiter-, NIS, Übergang oder mindestens einen Supraleiter-Isolator-Supraleiter-, SIS, Übergang umfasst.

3. Anordnung (100) gemäß Anspruch 1, wobei der mindestens eine Übergang der steuerbaren Energierelaxationsstruktur (102) einen Supraleiter-Isolator-Normalmetall-Isolator-Supraleiter-, SINIS, Übergang umfasst, und wobei das mindestens eine Qubit (101) elektromagnetisch mit dem Normalmetall des SINIS-Übergangs der steuerbaren Energierelaxationsstruktur (102) gekoppelt ist, und wobei das Steuersignal einer Spannungsvorspannung über dem SNIS-Übergang entspricht.

4. Anordnung (100) gemäß einem der vorhergehenden Ansprüche, wobei der Ladungsspeicher (104) durch mindestens eine kapazitive Kopplung zwischen dem mindestens einen Qubit (101) und der steuerbaren Energierelaxationsstruktur (102) und einer Kapazität des mindestens einen Übergangs der steuerbaren Energierelaxationsstruktur (102) gebildet ist.

5. Anordnung (100) gemäß einem der vorhergehenden Ansprüche, wobei mindestens ein Betriebsparameter des mindestens einen Übergangs in einer solchen Weise konfiguriert ist, dass, wenn das Steuersignal angelegt ist, eine photonenunterstützte Tunnelrate größer ist als eine elastische Tunnelrate in dem mindestens einen Übergang.

6. Anordnung (100) gemäß Anspruch 5, wobei der mindestens eine Betriebsparameter mindestens einer Betriebstemperatur unter 80 Millikelvin und einen Dynes-Parameter unter 10⁻⁴ umfasst.

7. Anordnung (100) gemäß einem der vorhergehenden Ansprüche, wobei das mindestens eine Qubit mindestens ein supraleitendes Qubit umfasst.

8. Quantencomputersystem (900), umfassend die Anordnung (100) gemäß einem der vorhergehenden Ansprüche und eine Steuereinheit (901), die mit der Anordnung (100) gekoppelt ist, wobei die Steuereinheit (901) dazu konfiguriert ist:
das Steuersignals an die steuerbare Energierelaxationsstruktur (102) der Anordnung bereitzustellen, und
das Auslesesignals, das durch die Ladungserfassungsstruktur (104) der Anordnung bereitgestellt wird, zu detektieren.

9. Quantencomputersystem (900) gemäß Anspruch 8, wobei das Steuersignal mindestens einen unipolaren Spannungsimpuls umfasst.

10. Quantencomputersystem (900) gemäß Anspruch 9, wobei eine Amplitude des mindestens einen unipolaren Spannungsimpulses einer Energie entspricht, die geringer als eine supraleitende Energielücke des mindestens einen Übergangs der steuerbaren Energierelaxationsstruktur und größer als eine Differenz der supraleitenden Energielücke des mindestens einen Übergangs der steuerbaren Energierelaxationsstruktur und einer Qubit-Energie des mindestens einen Qubits ist.

11. Quantencomputersystem (900) gemäß Anspruch 8, wobei das Steuersignal mindestens einen bipolaren Spannungsimpuls umfasst.

12. Quantencomputersystem (900) gemäß Anspruch 11, wobei der mindestens eine bipolare Spannungsimpuls zeitlich asymmetrisch ist.

13. Quantencomputersystem (900) gemäß einem der Ansprüche 11-12, wobei eine Amplitude eines ersten Polaritätsteils des mindestens einen bipolaren Spannungsimpulses einer Energie entspricht, die geringer als eine supraleitende Energielücke des mindestens einen Übergangs der steuerbaren Energierelaxationsstruktur und größer als eine Differenz der supraleitenden Energielücke des mindestens einen Übergangs der steuerbaren Energierelaxationsstruktur und einer Qubit-Energie des mindestens einen Qubits ist.

14. Verfahren (800) zur Qubit-Auslesung in der Anordnung gemäß einem der Ansprüche 1-7, umfassend:
Bereitstellen (1101) des Steuersignals an die steuerbare Energierelaxationsstruktur der Anordnung; und
Detektieren (1102) des Auslesesignals, das durch die Ladungserfassungsstruktur der Anordnung bereitgestellt ist.

15. Computerprogrammprodukt, das Instruktionen umfasst, die, wenn sie von dem Quantencomputersystem gemäß einem der Ansprüche 8-13 ausgeführt werden, das Quantencomputersystem veranlassen, das Verfahren gemäß Anspruch 14 durchzuführen.

## Revendications

1. Agencement (100) pour lecture de bits quantiques, comprenant :
au moins un bit quantique (101) ;
une structure de relaxation d'énergie commandable (102) comprenant au moins une jonction, dans lequel la structure de relaxation d'énergie commandable (102) est couplée au au moins un bit quantique (101), et est configurée pour absorber, en réponse à un signal de commande, au moins un photon provenant du au moins un bit quantique (101) par l'intermédiaire d'un tunnelage assisté par photons d'une charge à travers la au moins une jonction ;
un stockage de charge (104), configuré pour stocker la charge soumise à tunnelage ;
une structure de détection de charge (103) couplée au stockage de charge (104), configurée pour fournir un signal de lecture en réponse à une détection de la charge soumise à tunnelage dans le stockage de charge (104), dans lequel la structure de détection de charge (103) comprend un blocage de Coulomb commandant le signal de lecture, et dans lequel le blocage de Coulomb de la structure de détection de charge est modifié par la charge stockée dans le stockage de charge (104) couplé à la structure de détection de charge (103) et la structure de détection de charge (103) comprend un transistor à électron unique, SET, un transistor à paire de Cooper unique, SCPT, un transistor à électron unique à radiofréquence, RF-SET, un transistor inductif à électron unique, L-SET, ou une structure de détection de charge basée sur des points quantiques semi-conducteurs, des nanotubes de carbone, des contacts de point quantique, ou des matériaux bidimensionnels ; et
un canal de fuite de charge couplé au stockage de charge (104), configuré pour amener la charge soumise à tunnelage à décroître dans le stockage de charge (104).

2. Agencement (100) selon la revendication 1, dans lequel la au moins une jonction de la structure de relaxation d'énergie commandable (102) comprend au moins une jonction métal normal - isolant - supraconducteur, NIS, ou au moins une jonction supraconducteur - isolant - supraconducteur, SIS.

3. Agencement (100) selon la revendication 1, dans lequel la au moins une jonction de la structure de relaxation d'énergie commandable (102) comprend une jonction supraconducteur - isolant - métal normal - isolant - supraconducteur, SINIS, et dans lequel le au moins un bit quantique (101) est couplé électromagnétiquement au métal normal de la jonction SINIS de la structure de relaxation d'énergie commandable (102), et dans lequel le signal de commande correspond à une polarisation de tension sur la jonction SINIS.

4. Agencement (100) selon une quelconque revendication précédente, dans lequel le stockage de charge (104) est formé par au moins un couplage capacitif entre le au moins un bit quantique (101) et la structure de relaxation d'énergie commandable (102) et une capacitance de la au moins une jonction de la structure de relaxation d'énergie commandable (102).

5. Agencement (100) selon une quelconque revendication précédente, dans lequel au moins un paramètre de fonctionnement de la au moins une jonction est configuré de telle manière que, lorsque le signal de commande est appliqué, un taux de tunnelage assisté par photons soit supérieur à un taux de tunnelage élastique dans la au moins une jonction.

6. Agencement (100) selon la revendication 5, dans lequel le au moins un paramètre de fonctionnement comprend au moins une température de fonctionnement inférieure à 80 mK et un paramètre de Dynes inférieur à 10⁻⁴.

7. Agencement (100) selon une quelconque revendication précédente, dans lequel le au moins un bit quantique comprend au moins un bit quantique supraconducteur.

8. Système de calcul quantique (900) comprenant l'agencement (100) selon une quelconque revendication précédente et une unité de commande (901) couplée à l'agencement (100), dans lequel l'unité de commande (901) est configurée pour :
fournir le signal de commande à la structure de relaxation d'énergie commandable (102) de l'agencement ; et
détecter le signal de lecture fourni par la structure de détection de charge (104) de l'agencement.

9. Système de calcul quantique (900) selon la revendication 8, dans lequel le signal de commande comprend au moins une impulsion de tension unipolaire.

10. Système de calcul quantique (900) selon la revendication 9, dans lequel une amplitude de la au moins une impulsion de tension unipolaire correspond à une énergie inférieure à une énergie d'espace supraconducteur de la au moins une jonction de la structure de relaxation d'énergie commandable et supérieure à une différence de l'énergie d'espace supraconducteur de la au moins une jonction de la structure de relaxation d'énergie commandable et d'une énergie de bit quantique du au moins un bit quantique.

11. Système de calcul quantique (900) selon la revendication 8, dans lequel le signal de commande comprend au moins une impulsion de tension bipolaire.

12. Système de calcul quantique (900) selon la revendication 11, dans lequel la au moins une impulsion de tension bipolaire est temporellement asymétrique.

13. Système de calcul quantique (900) selon l'une quelconque des revendications 11 à 12, dans lequel une amplitude d'une première partie de polarité de la au moins une impulsion de tension bipolaire correspond à une énergie inférieure à une énergie d'espace supraconducteur de la au moins une jonction de la structure de relaxation d'énergie commandable et supérieure à une différence de l'énergie d'espace supraconducteur de la au moins une jonction de la structure de relaxation d'énergie commandable et d'une énergie de bit quantique du au moins un bit quantique.

14. Procédé (800) de lecture de bits quantiques dans l'agencement selon l'une quelconque des revendications 1 à 7, comprenant :
la fourniture (1101) du signal de commande à la structure de relaxation d'énergie commandable de l'agencement ; et
la détection (1102) du signal de lecture fourni par la structure de détection de charge de l'agencement.

15. Produit de programme d'ordinateur comprenant des instructions, qui, lorsque exécutées par le système de calcul quantique selon l'une quelconque des revendications 8 à 13, amènent ledit système de calcul quantique à réaliser le procédé selon la revendication 14.
